# EUROPÄISCHE PATENTSCHRIFT

(11) **EP 0 658 416 B1**
(45) Veröffentlichungstag und Bekanntmachung des Hinweises auf die Patenterteilung: **07.02.2001**
(21) Anmeldenummer: 94810634.9
(22) Anmeldetag: 02.11.1994
(51) Int. Cl.: B29C 59/14

(54) **Verfahren zur Strukturierung von Polymerfolien**
Method for texturing polymer foils
Procédé pour la formation d'un motif sur des feuilles plastiques

(30) Priorität: 23.11.1993 CH 348693
(43) Veröffentlichungstag der Anmeldung: 21.06.1995
(73) Patentinhaber: DYCONEX PATENTE AG, 6300 Zug (CH)
(72) Erfinder: Schmidt, Walter, CH-8050 Zürich (CH); Schmid, Hermann, D-85591 Vaterstetten (DE)
(74) Vertreter: Frei, Alexandra Sarah

(56) Entgegenhaltungen:
- EP-A- 0 129 199
- WO-A-85/04121
- DE-A- 4 232 998
- US-A- 4 445 966
- PATENT ABSTRACTS OF JAPAN vol. 8 no. 111 (E-246) ,24.Mai 1984 & JP-A-59 025227 (HITACHI SEISAKUSHO) 9.Februar 1984,
- PATENT ABSTRACTS OF JAPAN vol. 12 no. 338 (C-527) ,12.September 1988 & JP-A-63 099243 (MAZDA MOTOR) 30.April 1988,
- PATENT ABSTRACTS OF JAPAN vol. 11 no. 242 (C-438) [2689] ,7.August 1987 & JP-A-62 050335 (TOYODA GOSEI) 5.März 1987,
- PATENT ABSTRACTS OF JAPAN vol. 11 no. 133 (C-418) ,25.April 1987 & JP-A-61 268730 (MAZDA MOTOR) 28.November 1986,
- PATENT ABSTRACTS OF JAPAN vol. 11 no. 297 (C-448) [2744] ,25.September 1987 & JP-A-62 089736 (DAIHATSU MOTOR) 24.April 1987,

## Beschreibung

Die Erfindung liegt auf dem Gebiet der Verarbeitungstechnik unter Plasmaeinwirkung und betrifft ein Verfahren zur Strukturierung von beispielsweise Isolatorschichten in Leiterplatten und Folienleiterplatten bzw. Polymerfolien.

Heutzutage werden Folien aus Polymermaterialien in vielen technischen Anwendungsgebieten eingesetzt. Ein solches Anwendungsgebiet mit besonders hohen Anforderungen bezüglich der Miniaturisierung von Funktionen, Strukturen, Masse und Dicke dieser Folien usw. ist die Leiterplattentechnik. Leiterplatten sind bekanntlich einlagige oder mehrlagige gedruckte Schaltungen, welche aus einer Kombination flacher Strompfade, Sacklöcher und Durchplattierungen (Verbindungen verschiedener Lagen der gedruckten Schaltungen) und Isolatorschichten bestehen. In Folienleiterplatten werden Strompfade oft in dünnen elektrisch leitenden Folien strukturiert und als Isolatorschichten bzw. Dielektrika werden elektrisch isolierende Folien verwendet.

Eine bekannte, wirtschaftliche und universell einsetzbare Herstellungsmethode für kleine Strukturierungen in Polymerfolien ist das Plasma-Ätzen. Plasma-Ätzen besitzt den Vorteil, dass man eine beliebig grosse Zahl an Löchern bzw. Lochstrukturen simultan auf grossen Flächen erzeugen kann.

Als nächstliegender Stand der Technik kann das in der Patentschrift US-4720322 beschriebene Verfahren zum Plasma-Ätzen isolierender Folien zitiert werden. Es wird ein Plattenreaktor verwendet, der mit Paaren parallel zueinander angeordneter plattenförmiger Elektroden ausgerüstet ist und der ein Gasgemisch über Wechselspannungen im Bereich von 40 kHz bis 13,56 MHz (vorzugsweise 100 kHz) zu einem Plasma anregt. Der Reaktor is evakuierbar, zur Erzeugung des Plasmas wird ein Gemisch von Sauerstoff (O₂) und Tetrafluorkohlenstoff (CF₄) bei Unterdruck durch ein elektrisches Wechselfeld mit Frequenzen im Bereich von 40 kHz bis 13,56 MHz angeregt. Die im Plasma entstehenden lonen werden durch eine überlagerte elektrische Beschleunigungsspannung auf das Ätzgut hin beschleunigt und erzeugen dort Sacklöcher. In einem genannten Beispiel werden auf diese Art und Weise in Epoxyd-Aramid-Material nach 4 Stunden Ätzen Sacklöcher von 50 bis 100 µm Tiefe gebildet.

In der Patentschrift EP-0144943 wird ein weiteres Verfahren zum Plasma-Ätzen von Polyimid-Folien beschrieben, welches ebenfalls einen Plattenreaktor verwendet und welches eine möglichst hohe Unterätzung des Ätzguts zur Aufgabe hat. Das Ätzgut besteht aus beidseitig kupferkaschierten Polyimid-Folien (je 35 µm Kupfer, je 25 µm Acrylkleber und Polyimid, Du Pont LF9111). Diese Folien werden gemäss Masken in Form von Öffnungen in den Kupferschichten bei Frequenzen von 13,56 MHz in 70 Minuten durchgeätzt.

Die Patentschrift EP-0129199 zeigt einen Plasmareaktor für die Oberflächenbehandlung von Autoteilen aus Polymeren, in welchem eine Bestimmung der Plasmadichte entweder durch Messung des emittierten Plasmalichtes oder durch Messung der reflektierten Mikrowellenleistung oder durch Messung eines Ionenstroms erfolgt.

Ein Nachteil des genannten Stands der Technik beruht in ihrer geringen Ätzrate. Zwar lassen sich klein dimensionierte Strukturen wohl gleichzeitig erzeugen, doch dauert dies lange. Zudem besitzen die zu ätzenden, dünnen Folien eine sehr geringe Wärmekapazität und erhitzen sich beim Ätzen sehr rasch.

Um eine Überhitzung und damit eine Zerstörung der Folien zu vermeiden, muss die eingekoppelte Leistung niedrig gehalten werden, was aber die Plasmadichte absinken lässt und wiederum die Ätzrate erniedrigt.

Ein weiterer Nachteil des genannten Stands der Technik besteht erfahrungsgemäss in der geringen Uniformität der Ätzrate in derartigen Plattenreaktoren, d.h. die Löcher werden in zentralen Bereichen schneller als in Randzonen durchgeätzt. Um alle Löcher einer Folie zuverlässig durchätzen zu können, werden die Löcher in zentralen Bereichen der Folien überätzt. Diese geringe Uniformität wird überdies noch verstärkt, wenn das Ätzgut nicht homogen erwärmt wird, was insbesondere immer dann der Fall ist, wenn die zu ätzende Folie mit anderen Komponenten, wie Plattenelektrode oder Halter in thermischen Kontakt gebracht werden muss.

Es wäre wünschenswert, die Formvielfalt von Strukturierungen in Polymerfolien, beispielsweise in Isolatorschichten von Leiterplatten und Folienleiterplatten zu erweitern und zu verfeinern und solche Strukturierungen rasch, gleichmässig und materialschonend auszuführen.

Die Aufgabe der vorliegenden Erfindung besteht darin, ein Verfahren zur Strukturierung von Polymerfolien aufzuzeigen, welches eine rasche, homogene und materialschonende Herstellung solcher Strukturierungen ermöglicht.

Diese Aufgabe wird durch die in den Patentansprüchen definierte Erfindung gelöst.

Die Erfindung gibt ein Verfahren an, welches in einem Plasmareaktor mit vielfältigen Kontrollmöglichkeiten der Verfahrensparameter betrieben wird. Diese Kontrolle ermöglicht eine Optimierung der wichtigsten Verfahrensparameter. Optimiert wird das Verfahren in Funktion der Oberflächentemperatur von Polymerfolien wie beispielsweise Leiterplatten und Folienleiterplatten.

Schonende Strukturierungen werden bei Temperaturen unter einer kritischen, materialschädigenden Grenztemperatur der Polymerfolien plasmaerodiert. Um eine hohe Abtragrate zu erzielen, werden die Strukturierungen bei möglichst hohen Temperaturen und möglichst hoher Plasmadichte vorgenommen. Daneben sorgen eine möglichst gleichmässige Temperaturverteilung auf der Oberfläche von Polymerfolien, sowie ein möglichst homogener Gasfluss, wie auch eine während der Strukturierung ausgeführte Bewegung der Polymerfolien im Plasma, für eine über deren gesamten flächigen Ausdehnung gleichmässig hohe Erosionsrate.

Erfindungsgemäss wird also die Oberflächentemperatur und deren Verteilung auf den Polymerfolien gemessen, beispielsweise über Pyrometer und die Verfahrensparameter des Plasmareaktors dann so optimiert, dass bei Oberflächentemperaturen nahe unterhalb einer kritischen Temperatur und bei möglichst dichtem Plasma gearbeitet wird. Ein möglichst dichtes Plasma erhält man bei optimalen (homogenen) Gasgemischen in einem bestimmten Fluss-und Druckbereich, mit hohen Leistungsdichten eines Mikrowellensenders und bei hohen Anregungsfrequenzen.

Die Temperatur der Polymerfolien ist somit wegen der kritischen, materialschädigenden Grenztemperatur ein dominierender Verfahrensparameter. Aber sie ist auch sonst von Bedeutung. Hierbei ist es weniger die chemische Reaktion an der Oberfläche des abzutragenden Materials, die natürlich auch von der Temperatur abhängig ist, als die Desorptionsrate der Reaktionsprodukte, die sehr rasch mit der Temperatur ansteigt. Mit steigender Temperatur kann die Reaktionskinetik besser gestaltet werden, wodurch hohe Erosionsraten erzielt werden. Vorteilhafterweise wird die Oberflächentemperatur so gewählt, dass einerseits noch keine thermische Zerstörung der Polymerfolien eintritt, andererseits aber zu einer möglichst hohen Erosionsrate führt. Diese optimale Grenztemperatur variert für die verschiedenen Kunststoffe, die zur Herstellung von Polymerfolien verwendet werden. Schliesslich lässt sich auch der Temperaturverlauf optimieren. Dünne Polymerfolien mit einer sehr kleinen Wärmekapazität werden bei der Strukturierung rasch auf hohe Temperaturen erwärmt, während beispielsweise Leiterplatten, die dicker sind, und einen hohen Anteil an Kupfer aufweisen, sich bei der Strukturierung nur langsam erwärmen und demnach einer längeren Erosion bedürfen.

Es ist bekannt, dass die Plasmadichte bei gegebener Mikrowellenleistung mit steigender Anregungsfrequenz zunimmt bis alle Teilchen ionisiert sind, um dann in eine Sättigung zu treten. Dieses Sättigungsniveau ist vom vorhandenen Gasdruck abhängig. Bei hohen Gasdrucken von ca. 1 hPa ist die freie Weglänge der Teilchen so klein, dass einerseits die Beschleunigung der ionisierten Teilchen im elektrischen Wechselfeld - bedingt durch die hohe Stosswahrscheinlichkeit bei hohen Drucken - sehr klein ist, andererseits aber auch die Rekombinationswahrscheinlichkeit ansteigt und somit die Plasmadichte absinkt. Bei niedrigen Drucken kleiner 0,1 hPa ist die freie Weglänge der Teilchen so gross, um eine hinreichend hohe Beschleunigung ohne störende Zwischenstösse zu erreichen, und auch die Rekombinationswahrscheinlichkeit ist bedeutend geringer. Andererseits ist nun das Angebot an zu ionisierenden Teilchen stark reduziert, sodass bei Drucken von 0,1 hPa und darunter die Plasmadichte wieder absinkt. Im Zwischenbereich dieses Parameterfelds liegt ein Gebiet optimal hoher Plasmadichte mit hoher Erosionsrate und optimaler Abschirmung des elektrischen Hochfrequenzfelds, sodass die Polymerfolien rasch plasmaerodiert werden und vor Überhitzung geschützt sind.

Ein weiterer wichtiger Verfahrensparameter ist der Gasfluss, d.h. das Angebot an neuen reaktionsfähigen Teilchen pro Zeiteinheit. Bei zu niedrigem Gasfluss verbrauchen sich die reaktiven Teilchen des Plasmas rasch, es reichert sich mit Reaktionsprodukten an, wodurch die Plasmadichte und damit die Erosionsrate absinken. Diese hohe Konzentration der Reaktionsprodukte im Plasma führt sogar zu deren Rückdeposition auf den Polymerfolien. Dies führt naturgemäss zu einer Abnahme der Erosionsrate. Bei zu hohem Gasfluss ist die Verweilzeit der reaktiven Teilchen in der Kammer für eine effektive Erosion zu kurz, was wiederum zu einem Absinken der Erosionsrate führt. Also lässt sich bezüglich des Gasdrucks und des Gasflusses ein optimales Parameterfeld abstecken, in dem neben einer optimal hohen Erosionsrate, eine schonende Strukturierung der Polymerfolien ohne Überhitzung möglich ist.

Die Mikrowellenfrequenz ist ein weiterer Verfahrensparameter. Erfindungsgemäss erfolgt die Mikrowellenanregung im Bereich von GHz-Frequenzen, was den Vorteil hoher Plasmadichten und einer Abschirmwirkung des Plasmas gegenüber der Mikrowellenstrahlung aufweist. Die Mikrowellenenergie wird bei Frequenzen von 2,45 GHz besser vom Gasgemisch absorbiert und somit nur zu einem kleinen Teil in die Polymerfolien eingekoppelt, sodass deren Temperatur nicht auf überkritische Werte ansteigen kann. Natürlich lassen sich zur Plasmaanregung auch Mikrowellen mit niedrigeren Frequenz als 2,45 GHz verwenden, beispielsweise Frequenzen der in den oben beschriebenen Verfahren im kHz- bzw. MHz-Bereich. Allerdings ist dann das Plasma weniger dicht und dementsprechend ist die Erosionsrate wesentlich niedriger, und die Abschirmwirkung des Plasmas gegenüber der Mikrowellenstrahlung ist geringer, sodass Mikrowellenstrahlung auf den Polymerfolien vermehrt absorbiert wird und deren Überhitzung bewirkt.

In der Erfindung werden Mikrowellen durch Magnetrons als Mikrowellensender mit einer Frequenz von 2,45 GHz erzeugt, was um rund zwei Grössenordnungen über denjenigen bekannter Verfahren liegt. Bei Gasdrucken von 0,1 - 1 hPa und Gasflüssen von einigen 100 ml/min werden bei der Strukturierung von Polymerfolien Erosionsraten im Bereich von 2 - 3 µm/min erzielt, was gegenüber den bekannten Verfahren eine Beschleunigung um den Faktor 3 - 4 darstellt. Dieser Geschwindigkeitsgewinn erlaubt es kompliziert geformte Strukturierungen in relativ kurzen Zeiten von 10 - 20 Minuten herzustellen. Es lassen sich die unterschiedlichsten Kunststoffmaterialien strukturieren, wobei oben genannten grundsätzlichen Überlegungen für alle diese Materialien gelten. Die absolute Höhe der Erosionsrate ist naturgemäss von der Art des Materials, dessen chemischen Aufbau und Vernetzungsgrad abhängig. Dieses neuartige Verfahren wird Plasmaerosion genannt und die vielfältig geformten Strukturierungen werden als Mikroformungen bezeichnet. Dieses Verfahren ist vollumfänglich für die Herstellung von Leiterplatten und Folienleiterplatten einsetzbar und mit bekannten und bewährten Methoden der Leiterplattentechnik kompatibel.

Anhand der nachfolgend aufgeführten Figuren 1 bis 7 wird das erfindungsgemässe Verfahren zur Herstellung von Mikroformungen in Polymerfolien näher erläutert.
- Fig. 1: zeigt schematisch den Aufbau eines Teils einer ersten Ausführungsform eines Plasmareaktors für das erfindungsgemässe Verfahren.
- Fig. 2: zeigt ein Diagramm eines Parameterfelds mit optimierten Parametern und hohen Erosionsraten.
- Fig. 3: zeigt nach dem erfindungsgemässen Verfahren hergestellte Mikroformungen in Polymerfolien in der Ausführungsform einer zweilagigen Folienleiterplatte.
- Fig. 4: zeigt schematisch den Aufbau eines Teils einer zweiten Ausführungsform eines Plasmareaktors für das erfindungsgemässe Verfahren.
- Fig. 5: zeigt ein Diagramm mit Temperaturprofilen der Plasmaerosion.
- Fig. 6: zeigt ein Fliessschema der Parameteroptimierung des Verfahrens.
- Fig. 7: zeigt ein Fliessschema der Speicherung und der Bereitstellung optimierter Parametersätze des Verfahrens.

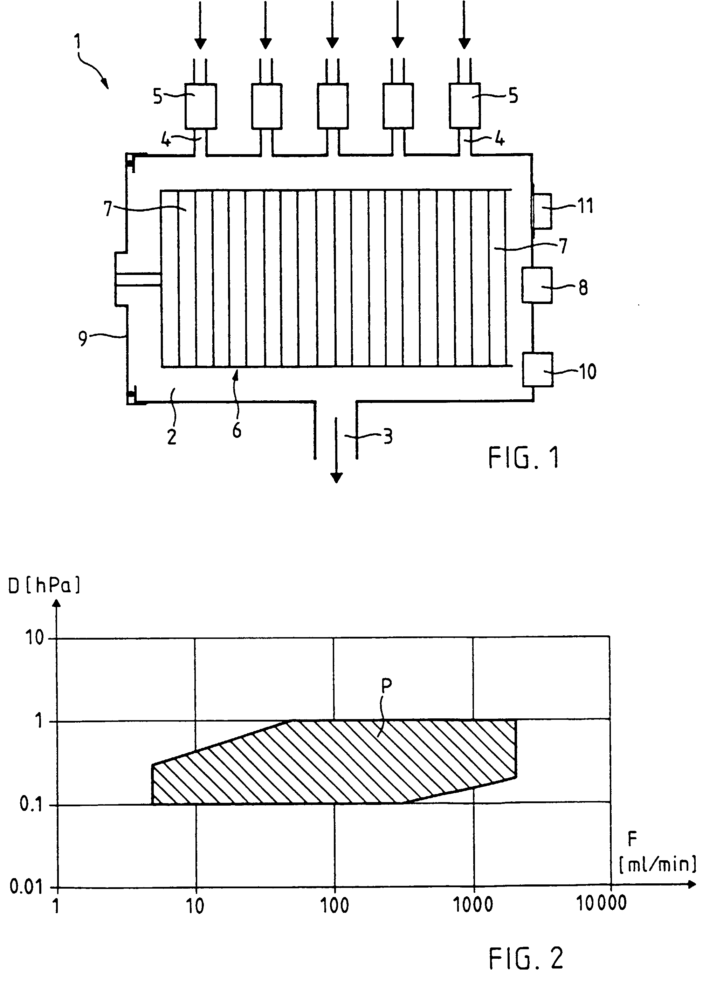

**Figur 1** zeigt schematisch den Aufbau eines Teils einer ersten Ausführungsform eines Plasmareaktors für das erfindungsgemässe Verfahren. Dessen Kammer oder Rezipient 2 ist über Ansaugstutzen 3 und Pumpen evakuierbar (siehe Pfeile). Gasgemische sind über Einlassstutzen 4 und Flussregler 5 regelbar einlassbar (siehe Pfeile). Vorteilhafterweise liegen die Gasflüsse im Bereich von 50 bis 2000 ml/min. Der Kammerdruck wird mittels Druckaufnehmer 10 gemessen. Vorteilhafterweise beträgt der Arbeitsdruck zwischen 0,1 und 1 hPa. Für die Plasmaerosion werden Gasgemische, bestehend aus Gasen wie O₂, CF₄, SF₆ und C₂F₆ verwendet, die sich schon beim Plasma-Ätzen bewährt haben. Vorteilhafte Gasgemische weisen einen Überschuss an O₂ mit einem Anteil von 3 bis 25% CF₄ auf. Der optimale CF₄-Anteil liegt im Bereich von 6 bis 16%. Der Rezipient 2 lässt sich mittels einer vakuumdicht ver-schliessbaren Tür 9 öffnen, um so die Polymerfolien an einem Beschickungskorb 6 anzubringen, beispielsweise durch Einspannen. Natürlich ist auch ein Betrieb möglich, wo der Rezipient 2 zum Beschicken nicht geöffnet werden muss. So können Polymerfolien 7 auch kontinuierlich, von Rolle verarbeitet werden, sie würden über dichte Durchführungen kontinuierlich in den Rezipienten 2 geführt und diesen dann auf Führungsmitteln geführt durchqueren (siehe eine entsprechende Schweizerische Patentanmeldung von der gleichen Erfinderin mit der Anmeldenummer 00987/93-3 vom 31.03.1993). Der Mikrowellensender 8, beispielsweise ein Magnetron, emittiert Mikrowellen mit einer festen und hohen Anregungsfrequenz von 2,45 GHz. Von Gesetzes Wegen her ist Anzahl möglicher Mikrowellenfrequenzen beschränkt, unter den zur Verfügung stehenden Frequenzen bietet sich die Verwendung von 2,45 GHz an. Die Leistungsdichte ist einstellbar und beträgt für rasche Plasmaerosion mehr als 10 Watt/Liter. Die Temperatur und die Temperaturverteilung sind über ein Pyrometer 11 lokal bestimmbar. Für Isolatorschichten wie Polyimidfolien sollte die Oberflächentemperatur 200 °C nicht übersteigen.

Im erfindungsgemässen Verfahren der Plasmaerosion wird vorteilhafterweise so vorgegangen, dass Polymerfolien 7 in den Beschickungskorb 6 angebracht werden, dass der Rezipient 2 auf einen Basisdruck unterhalb des Arbeitsdrucks evakuiert wird, dass ein Gasgemisch in den Rezipienten 2 eingelassen wird, dass sich Gasfluss und Kammerdruck stabilisieren, dass dann der Mikrowellensender 8 angeschaltet wird und dass die Sendeleistung eingestellt wird, sodass im Gasgemisch ein Plasma gezündet wird. Das Plasma lässt sich überall in den Rezipienten 2 von Mikrowellen angeregen. Dadurch, dass kontinuierlich Gasgemische eingelassen und abgepumpt werden, treffen die reaktiven Teilchen des Plasmas auf die Isolatorschichten und erodieren sie es zu Mikroformungen. Durch Kontrolle der Temperatur wird die Erosionsrate hoch und homogen gehalten. Nach Beendigung dieser Strukturierung, beispielsweise nach Ablauf einer bestimmten Erosionsdauer, wird der Mikrowellensender 8 ausgeschaltet, die Gaszufuhr gestoppt und der Rezipient 2 belüftet, um die Polymerfolien zu entnehmen.

Die wichtigsten Verfahrensparameter der Plasmaerosion sind also der Gasdruck, der Gasfluss, die Oberflächentemperatur der Polymerfolien, die Gasart und die Zusammensetzung des Gasgemischs und schliesslich die Leistung des Mikrowellensenders. Alle diese Parameter sind mess- und regelbar, sie lassen sich durch einen Computer steuern und der Plasmareaktor 1 lässt sich somit vollautomatisch steuern Eine solche Steuerung bedingt auch eine Optimierung der Verfahrensparameter, bzw. eine Bestimmung optimaler Parametersätze. Im erfindungsgemässen Verfahren werden die Parameter in Bezug auf den Parameter Oberflächentemperatur optimiert. Die Oberflächentemperatur wird während der Strukturierungen durch das Plasma kontrolliert und durch entsprechende Einstellung der Parameter knapp unterhalb der materialschädigenden Grenztemperatur für Polymerfolien gehalten, um Mikroformungen schonend zu erodieren.

**Figur 2** zeigt eine solche Optimierung der Verfahrensparameter, wobei in einem Diagramm ein Bereich hoher Erosionsraten auf einer Isolatorschicht in Funktion der Parameter Gasfluss F in ml/min und Gasdruck D in hPa abgebildet ist. Die anderen Parameter wie Oberflächentemperatur, Zusammensetzung des Gasgemischs und Mikrowellenleistung werden optimal konstant gehalten. Eine rasche Plasmaerosion benötigt ein dichtes Plasma bei möglichst hohen Oberflächentemperaturen, der Existenzbereich eines solch dichten Plasmas lässt sich in einem Parameterfeld P nach apparativen und physikalischen Grenzbedingungen bezüglich des Gasflusses F und des Gasdrucks D ermitteln. Diese Grenzbedingungen sind minimale Gasflüsse und Gasdrucke und maximale Gasflüsse und Gasdrucke. Bei Gasflüssen F kleiner 50 ml/min sinkt die Erosionsrate stark ab, da zu wenige reaktive Teilchen des Plasmas im Rezipienten 2 vorhanden sind. Bei Gasflüssen F grösser 2000 ml/min hingegen ist die Verweildauer der reaktiven Teilchen im Rezipienten 2 so gering (es muss stärker abgepumpt werden, um den Gasdruck D zu halten), dass die Erosionsrate stark abnimmt. Bei Gasdrucken D kleiner 0,1 hPa ist der Wärmeübertrag durch nichtabsorbierte Mikrowellen in die Isolatorschichten so hoch, dass diese durch Überhitzung zerstört werden könne. Bei Gasdrucken D grösser 1 hPa ist die Rekombinationswahrscheinlichkeit der Ionen und Radikale im Plasma so hoch, sodass die Erosionsrate drastisch abnimmt. Das Parameterfeld P definiert einen Optimalbereich, der sich mit veränderlicher Mikrowellenleistung nur wenig ändert. Daher kann man durch Steuerung der Mikrowellen-Leistung eine optimal hohe Oberflächentemperatur einstellen, ohne die übrigen Parameter verändern zu müssen.

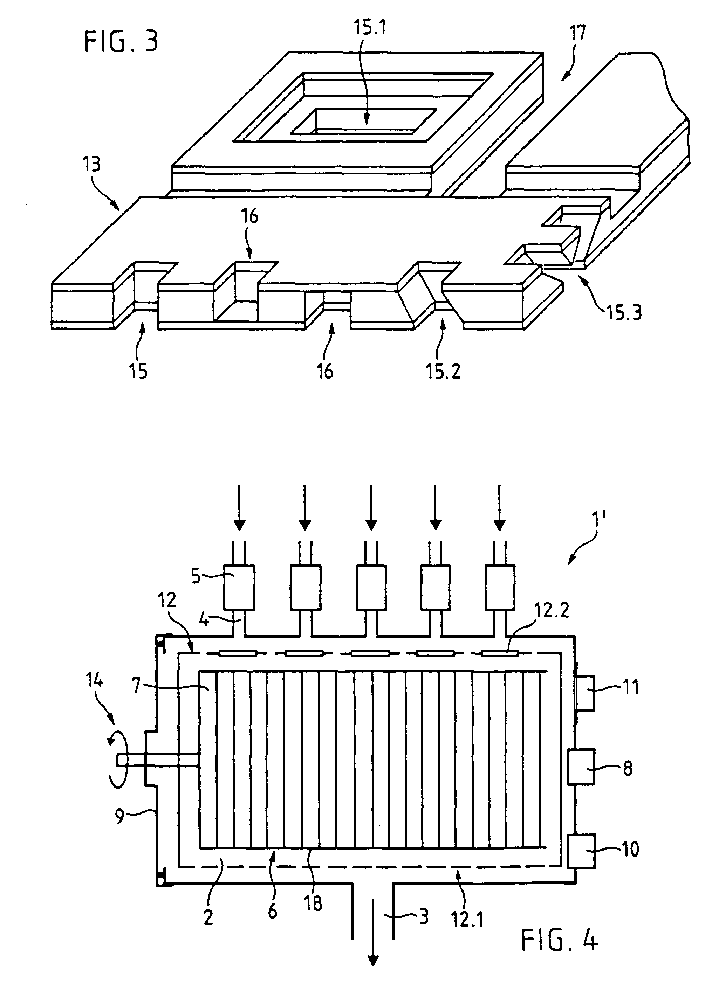

**Figur 3** zeigt nach dem erfindungsgemässen Verfahren hergestellte Mikroformungen in Polymerfolien in der Ausführungsform einer zweilagigen Folienleiterplatte. Diese Folienleiterplatte besteht aus einer 50 µm dicken, beidseitig mit dünnen Kupferfolien auflaminierten Polyimidfolie 13 von bspw 250×250 mm² Fläche als Isolatorschicht. Ein solches Verfahren zum Anbringen kleiner Löcher in solchen Folienleiterplatten wird in einer Patentanmeldung von der gleichen Erfinderin mit der Anmeldenummer PCT/CH93/00145 vom 09.06.1993 beschrieben. 5% der Kupferfolienflächen sind in vorhergehenden Arbeitsschritten, beispielsweise durch nasschemisches Ätzen, bis auf die Polyimidfolie 14 freigelegt worden und bildeten so eine Maske für die Plasmaerosion. Ein für die Plasmaerosion typisches Gasgemisch, bestehend aus 92% O₂ und 8% CF₄, wird bei einem Gasfluss von 500 ml/min und bei einem Gasdruck von 0,4 hPa durch Mikrowellen von 2,45 GHz und bei einer Leistungsdichte von 18 Watt/Liter zu einem Plasma angeregt, wobei die Oberflächentemperatur der Folienleiterplatte unterhalb 200 °C liegt. Auf diese Weise werden in der Polyimidschicht innerhalb 23 Minuten Durchgangslöcher 15 erodiert, also mit einer Erosionrate von 2,2 µm/min. Des weiteren lassen sich eine Vielzahl anderer, zum Teil komplizierte Mikroformungen strukturieren. So können neben den Durchgangslöchern 15 auch einfach schräge Durchgangslöcher 15.2, doppelt schräge Durchgangslöcher 15.3, durchgehende Fenster 15.1 und Sacklöcher 16 und durchgehende Rillen 17 geformt werden.

Die Erosionsrate von 2,2 µm/min ist mindestens um einen Faktor 3 grösser als die Ätzraten der in den Patentschriften US-4720322 und EP-0144943 beschriebenen Verfahren zum Plasma-Ätzen. Um die Raten der verschiedenen erodierten und geätzten Materialien dieser Verfahren miteinander vergleichen zu können, sind deshalb materialspezifische Umrechnungen vorgenommen worden. So lässt sich das Epoxy-Aramid-Material der US-Patentschrift rund 30% schneller ätzen als Polyimid, womit man eine auf Polyimid bezogene Rate von ungefähr 0,13 bis 0,26 µm/min erhält. Die kupferkaschierten Polyimidfolien (Du Pont LF9111) der EP-Patentschrift weist 300% schneller zu ätzenden Akrylkleber auf, sodass hier man eine auf Polyimid bezogene Rate von 0,5 bis 0,6 µm/min erhält.

**Figur 4** zeigt schematisch den Aufbau eines Teils einer zweiten Ausführungsform eines Plasmareaktors für das erfindungsgemässe Verfahren. Dieser Plasmareaktor 1' ist weitgehend identisch mit demjenigen gemäss Figur 1, sodass im folgenden nur die Erweiterungen der zweiten Ausführungsform beschrieben werden. Diese Erweiterungen zielen auf möglichst gleichmässige Verteilungen der Oberflächentemperatur und des Gasflusses hin. Die Anordnungen und Bewegungen der Polymerfolien im Rezipienten sind möglichst gleichförmig, um so homogene Mikroformungen zu erodieren.

Das Konzept der Temperaturkontrolle wird hier erweitert und vertieft. Es geht nicht mehr nur um das Erreichen hoher Temperaturen für eine rasche Plasmaerosion, sondern es werden jetzt auch möglichst gleichmässige Temperaturprofile auf den Polymerfolien 7 erzeugt. Hierfür sind im Plasmareaktor 1' weitere Vorrichtungen wie eine Heizung 12, Prallplatten 12.2 und Verteilerplatten 12.1, ein rotierender Beschickungskorb 6 mit speziellen Einspannvorrichtungen angebracht.

Die Heizung 12 dient der Minimierung der Wärmeabstrahlung in Richtung kalter Kammerbereiche, insbesonders in Richtung der Innenwände des Rezipienten 2. Die Kammerwände sind so auf eine Temperatur, möglichst nahe der kritischen Temperatur geheizt. Dieses Heizen kann geschehen, indem der Plasmareaktor 1' in einen Ofen gestellt wird, oder indem die Aussenwände des Rezipienten 2 über Heizbänder geheizt werden, oder indem die Innenwände des Rezipienten 2 über eine Heizung 12 geheizt werden. Die Heizung 12 kann aus Metall wie Aluminium gearbeitet und poliert sein, um als Strahlenschutz eine möglichst homogene Verteilung der Wärmestrahlung im Rezipienten zu erzielen. Die Heizung 12 kann auch passiv gearbeitet sein und nur aus dünnen Aluminiumplättchen bestehen, die die kalten Kammerbereiche weitgehend vor den Polymerfolien abschirmen. So kann sie sich während der Plasmaerosion durch Einfang von Mikrowellenstrahlen oder durch Kontakt mit heissen Teilchen rasch aufheizen und so einen zu grossen Temperaturgradienten zwischen den Polymerfolien und den Kammerwänden verhindern.

Die Gasflussverteilung ist ebenfalls ein wichtiger Faktor. So hängt die Erosionsrate sensibel vom Angebot reaktiver Teilchen im Plasma ab. Auch hängt sie stark davon ab, wie schnell die Reaktionsprodukte abgeführt werden. Wichtig sind also die Anordnung und Ausführung der Gaseinlässe, die Ausführung der Abpumpöffnungen und die Anordnung der Polymerfolien 7 bezüglich der Strömungsrichtungen des Gasgemischs im Plasmareaktor 1'.

Vorteilhafterweise wird das Gasgemisch vor dem Einlass gemischt und über gleichmässig an den Wänden des Rezipienten 2 verteilte Einlassstutzen 4 gleichmässig eingelassen. Das Ziel der Einlassvorichtung ist, überall auf den Polymerfolien gleichviele reaktive Teilchen pro Zeiteinheit bereitzustellen. Um dies optiomal durchzuführen, werden über einstellbare Düsen Korrekturen vorgenommen, beispielsweise durch die Flussregler 5, sodass unterschiedliche Mengen Gasgemisch durch unterschiedliche Öffnungen an verschiedenen Stellen des Rezipienten treten, um so in der gesamten Erosionszone, an den zu erodierenden Polymerfolien 7, ein optimales und homogenes Gasgemisch zu erzeugen. Nun haben Einlassdüsen den Nachteil, dass es im Rezipienten 2 oft zur Ausbildung keulenförmiger Gasströmungen kommt, was einer optimalen Gasausbreitung hinderlich ist. Dieser Nachteil wird durch das Anbringen von Prallplatten 12.2 behoben. Die Prallplatten 12.2 werden beispielsweise in die mit Öffnungen versehene Heizung 12 integiert und am Ausgang der Einlassstutzen 4 montiert, sodass das aus den Einlassstutzen 3 ausströmende Gasgemisch an ihnen verwirbelt wird.

Analog zu der Art der Gaseinlässe sind auch Lage und Anordnung der Abpumpöffnungen kritisch. Der in den Rezipienten 2 ragende Ansaugstutzen 3 erzeugt dort eine lokal übermässige Saugwirkung, die es zu vermeiden gilt. Vorteilhafterweise wird dazu über dem Ansaugstutzen 3 eine Verteilerplatte 12.1 in Form einer mit Löchern versehenen Aluminiumplatte angebracht, sodass das Gasgemisch nach Durchströmen des Rezipienten, durch diese Löcher homogen abgesaugt wird. In der Ausführungsform gemäss Figur 4 ist die Verteilerplatte 12.1 in der Heizung 12 integriert. Ein homogenes Absaugen kann beispielsweise durch unterschiedlich grosse und verschieden dicht angebrachte Löcher auf der Verteilerplatte 12.1 geschehen, sodass die Löcher mit zunehmender Entfernung vom Ansaugstutzen 3 grösser und dichter werden, um so die dementsprechend nachlassende Saugleistung zu kompensieren.

Eine weitere Homogenisierung der Temperaturverteilung wird durch Drehen der Polymerfolien 7 im Rezipienten 2 erreicht. Es hat sich als vorteilhaft herausgestellt, dass die zu erodierenden Polymerfolien 7 parallel zur Stömungsrichtung der Gase beschickt werden und in dieser Ausrichtung zum Gasfluss mittels eines Antriebs 14 um die Längsachse des Beschickungskorbs 6 gedreht werden. In dieser Ausrichtung parallel zum Gasfluss werden die zu erodierenden Oberflächen vom Gasgemisch in Längsrichtung umspült. Innerhalb der weitgehend geschlossenen Heizung 12 bildet sich so eine gerichtete Strömung mit geringem oder minimalem Widerstand aus, die von den Prallwänden 12.2 bis zu den Verteilerplatten 12.1 reicht. Diese Strömung lässt sich durch den Abstand der Polymerfolien 7 im Beschickungskorb 6 varieren. Vorteilhafterweise sollten die Polymerfolien 7 nicht zu eng gehangen werden, ihre Abstände untereinander sollten 10 mm nicht unterschreiten, ein Abstand von 20 mm erscheint bei den Gasflüssen und Gasdrucken optimal. Werden die Polymerfolien 7 zu weit auseinander gehangen, so nimmt der Füllgrad und der Durchsatz des Plasmareaktors 1' ab.

Schliesslich erfolgt eine Optimierung der Temperaturverteilung über die Art und Weise des Einspannens der Polymerfolien 7 in den Beschickungskörben 6 vorgenommen werden. Um das Auftreten von Wärmeflüssen durch direkten Kontakt unterschiedlich warmer Körper zu vermeiden, sind somit die Halterungen der Polymerfolien 7 aus besonders schlecht wärmeleitenden Materialien gearbeitet und die Kontaktstellen dieser Einspannvorrichtungen 18 sind besonders klein ausgeformt. Vorteilhafterweise werden die Polymerfolien 7 über Federklemmen aus Edelstahl mit spitzenförmigen Klemmflächen in die Beschickungskörbe 6 eingespannt.

Unter Berücksichtigung all dieser Massnahmen lässt sich eine Homogenität der Plasmaerosion von kleiner +/-5% erzielen. Dies stellt gegenüber gewöhnlichen Plasmareaktoren wie Plattenreaktoren eine bedeutende Verbesserung dar, wo Inhomogenitäten von 30% akzeptiert werden müssen.

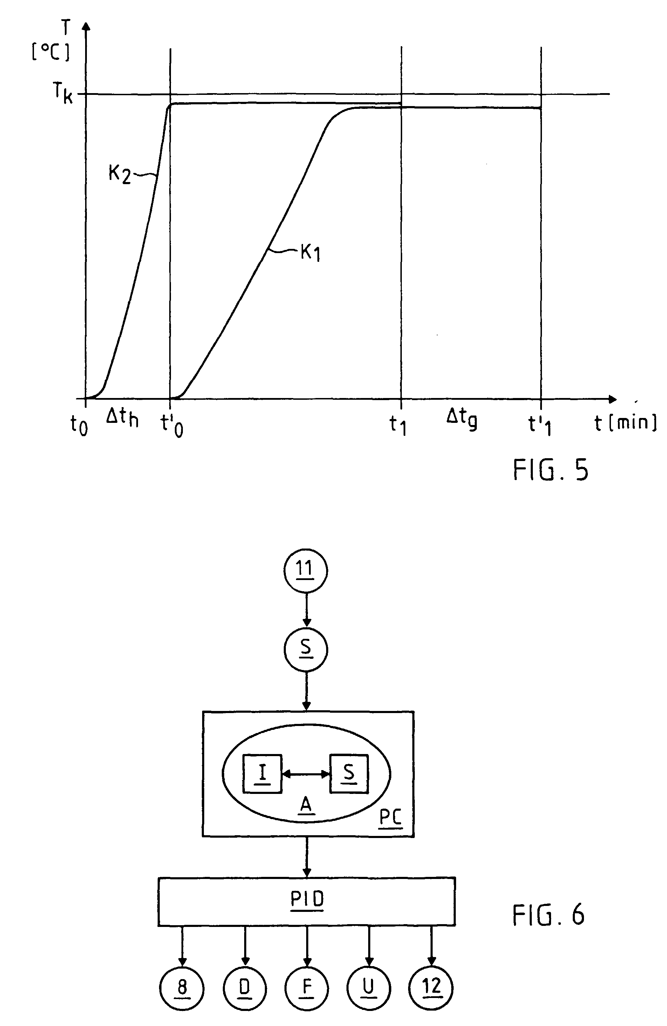

**Figur 5** zeigt ein Diagramm eines Temperaturprofils für rasche Plasmaerosion. Der Einfluss der Oberflächentemperatur auf die Erosionsraten in den Isolatorschichten wird über die Erosionsdauer aufgetragen und es wird gezeigt, dass die Dauer der Plasmaerosion der Polymerfolien durch Einschalten einer Vorheizphase Δtₕ um einen Betrag Δt_{g} verkürzt werden kann. Zwei Kurven K₁ und K₂ sind aufgetragen, die eine Kurve K₁ gibt die Oberflächentemperatur während der Plasmaerosion ohne eine Vorheizphase an, die andere Kurve K₂ gibt die Oberflächentemperatur während der Plasmaerosion nach vorgeschalteter Vorheizphase an. Die Vorheizphase Δtₕ beginnt zu einem Zeitpunkt t₀ und endet zu einem Zeitpunkt tₒ', die Oberflächentemperatur der Kurve K1 ist zu diesem Zeitpunkt bis nahe unterhalb der schädigenden kritischen Temperatur Tₖ gestiegen. Sie wird dann kontrolliert und vorteilhafterweise konstant nahe dieser kritischen Temperatur Tₖ gehalten. Die Plasmaerosion beginnt für beide Kurven K₁,K₂ zum Zeitpunkt t₀' und endet für die Kurve K₁ am Zeitpunkt t₁, für die Kurve K₂ endet sie am Zeitpunkt t₁'. Aus Figur 5 folgt, dass die Oberflächentemperatur der nicht vorgeheizten Kurve K₁ während der Plasmaerosion ansteigt und erst nach ungefähr einem Drittel der Erosionsdauer die kritische Temperatur Tₖ erreicht. Durch die relativ kalte Oberflächentemperatur im ersten Drittel der Plasmaerosion wird die Erosionsdauer relativ zur vorgeheizten Kurve K₂ verlängert. Die Vorheizphase Δtₕ beträgt rund 10% einer typischen Plasmaerosionsdauer, der Zeitgewinn Δt_{g} entspricht ungefähr der Zeit, die die Oberflächentemperatur der nicht vorgeheizten Kurve K₁ benötigt, um sich der kritischen Temperatur Tₖ zu nähern.

Verfahrensmässig wird die Vorheizphase durch ein Zünden eines nichterodierenden Plasmas, beispielsweise durch Stickstoff (N₂) oder Argon (Ar) bei hoher Mikrowellenleistung realisiert. Der Wärmeübertrag aus solchem Plasma ist unter ähnlichen Bedingungen sogar grösser als jener aus dem erodierenden Gasgemisch O₂/CF₄, deswegen steigt die vorgeheizte Kurve K₂ auch schneller gegen die Grenztemperatur Tₖ an als die nicht vorgeheizte Kurve K₁. Beispielsweise wird bei Verwendung von N₂, bei einem Fluss von 1000ml/min und bei einem Druck von 0,2 hPa eine Leistungsdichte von 20 Watt/Liter übertragen, eine solche Vorheizphase Δtₕ dauert 3 Minuten.

**Figur 6** zeigt ein Fliessschema der Parameteroptimierung bei der Plasmaerosion. Gemäss dieses Fliessschemas wird die Oberflächentemperatur optimiert. Über ein Pyrometer 11 wird kontinuierlich die Oberflächentemperatur einer Polymerfolien gerastert. Diese Daten werden über einen Signalintegrator S aufbereitet, beispielsweise in einem Computer PC. Sie können graphisch dargestellt oder auf Medien gespeichert werden und sie lassen sich beliebig weiterverarbeiten. Solche integrierten Daten, die beispielsweise das typenspezifische Temperaturverhalten einer Polymerfolie, beispielsweise einer Leiterplatte oder Folienleiterplatte beinhalten und die unterschiedliche Wärmekapazität dieser Platten widergeben, werden von einem Algorithmus A bezüglich ihres zeitlichen Verlaufs, ihrer Kontinuität und ihrer relativen Distanz zu einer oberen Grenztemperatur kontrolliert. Differenzen zwischen Sollwert S und Istwerten I der Oberflächentemperatur und des Temperaturprofils lassen sich regeln. Dies kann beispielsweise durch Ansteuern eines Temperaturreglers, wie eines PID-Reglers PID geschehen. Steigt beispielsweise die Temperatur über den kritischen Grenzwert, so kann über den PID-Regler die Leistung des Mikrowellensenders 8 gedrosselt werden. Misst man beispielsweise ein lokales Aufheizen in den Randbereichen (durch absorbierte Mikrowellenstrahlung), so kann daraufhin über den PID-Regler der Gasdruck D erhöht werden. Gemäss Figur 6 sind wichtige Parameter wie der Gasdruck D, der Gasfluss F, die Leistung des Mikrowellensenders 8, die Umdrehungszahlen U des rotierenden Beschickungskorbs und auch die Heizleistung der Heizung 12 regelbar (siehe Figur 4). Der Plasmareaktor lässt sich so vollautomatisch mit optimalen Parametern steuern.

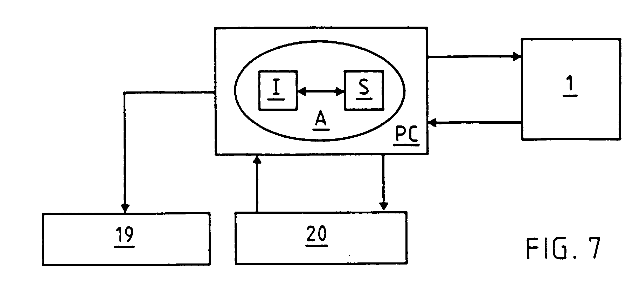

**Figur 7** zeigt ein Fliessschema der Speicherung und der Bereitstellung optimierter Parametersätze bei der Plasmaerosion. Gemäss diesem Fliessschema werden zur Erzielung einer maximalen Erosionsrate verkettete Sätze von Parametern wie Anregungsfrequenz, Gasdruck, Gasfluss, Verweildauer, Oberflächentemperatur, Rezipiententemperatur, Erosionsdauer, Anordnung und Bewegung der Polymerfolien als unabhängige Sätze für verschiedene maximierte Erosionsaufgaben zur Steuerung der Plasmaerosion eingesetzt. Aus der Menge der vorhandenen Sätze wird der jeweils für die Erosionsaufgabe gewünschte Satz zum Laden bereitgehalten. dieses Fliesschema ist demnach eine Erweiterung des Fliessschemas gemäss Figur 6. Während im Fliessschema gemäss Figur 6 abhängige Parameter in Funktion der Oberflächentemperatur überwacht und geregelt werden, erfolgt im Fliessschema gemäss Figur 7 eine Überwachung ganzer Parametersätze. Der Plasmareaktor lässt sich so vollautomatisch mit optimalen Parametersätzen steuern. Die Daten für Algorithmen A des Computers PC werden in Ablagen 19 als Bibliothek vorrätig gehalten und bei Bedarf in den Speicher 20 hochgeladen, sie werden dort quasi zwischengelagert. Jeder der gewählten Algorithmus A arbeitet jetzt mit ganzen Parametersätzen mit denen er den Plasmareaktor 1 in Abhängigkeit von Sollwerten S und Istwerten I steuert. Der Algorithmus A kann dabei interaktiv arbeiten, d.h. er besitzt das Expertenwissen bezüglich des Plasmareaktors, wie beispielsweise die optimalen Gasflüsse und die kritischen Grenztemperaturen für zu erodierende Materialien, und kann mit einem Techniker kommunizieren. Neue Parametersätze werden wieder in der Ablage 19 abgespeichert.

## Patentansprüche

1. Verfahren zur Strukturierung von Polymerfolien für Leiterplatten und/oder Folienleiterplatten mittels Plasmaeinwirkung,
unter Verwendung eines Rezipienten, in welchem Rezipienten Gasgemische eingelassen werden, welche Gasgemische durch elektromagnetische Strahlung energetisch zu einem Plasma angeregt werden welches Plasma die Polymerfolien strukturiert, wobei die Oberflächentemperatur der Polymerfolien im Rezipienten während der Strukturierung überwacht wird, **dadurch gekennzeichnet,** dass die Gasgemische durch Mikrowellen energetisch angeregt werden, dass der Gasdruck im Rezipienten während der Strukturierung überwacht wird,
dass zur Erzielung emer maximalen Erosionsrate verkettete Sätze von Parametern Anregungsfrequenz, Gasdruck, Gasfluss, Verweildauer, Oberflächentemperatur, Rezipiententemperatur, Erosionsdauer, Anordnung und Bewegung der Polymerfolien als unabhängige Sätze für verschiedene maximierte Erosionsaufgaben zur Steuerung der Plasmaerosion eingesetzt werden,
dass aus der Menge der vorhandenen Sätze jeweils der für die Ero- sionsaufgabe gewünschte Satz zum Laden bereitgehalten wird,
dass von den Gasgemischen eine Mikrowellenenergie mit einer Frequenz von 2.45 GHz oder kleiner absorbieren wird,
dass eine Leistungsdichte von mindestens 10 Watt/Liter eingestellt wird
und dass die Oberflächentemperatur knapp unterhalb einer materialschädigenden Grenztemperatur für Polymerfolien gesteuert wird, sodass Mikroformungen in Polymerfolien plasmaerodiert werden.

2. Verfahren gemäss Anspruch 1, **dadurch gekennzeichnet**, dass Mikroformungen bei homogener Verteilung von Oberflächentemperatur und vom Gasfluss und bei gleichartiger Anordnung und Bewegung der Polymerfolien homogen plasmaerodiert werden.

3. Verfahren gemäss Anspruch 1, **dadurch gekennzeichnet,** dass die Oberflächentemperatur durch den Gasdruck unterhalb der Grenztemperatur gehalten wird und dass der Gasdruck durch Fluss und Verweilzeit des Gasgemischs im Rezipienten eingestellt wird.

4. Verfahren gemäss Anspruch 1, **dadurch gekennzeichnet**, dass der Gasdruck biet genug eingestellt wird, um ein Aufheizen der Polymerfolien über die Grenztemperatur durch Kontakt mit dem Gasgemisch zu vermeiden und dass der Gasdruck hoch genug eingestellt wird, um ein Aufheizen der Polymerfolien über die Grenztemperatur durch vom Gasgemisch nichtabsorbierte Mikrowellen zu vermeiden.

5. Verfahren gemäss Anspruch 1, **dadurch gekennzeichnet**, dass die Mikrowellenfrequenz so hoch eingestellt wird, um ein möglichst dichtes und mit wachsender Frequenz besser Mikrowellen abschirmendes Plasma anzuregen.

6. Verfahren gemäss Anspruch 1, **dadurch gekennzeichnet**, dass die Oberflächentemperatur durch Einstellung der Leistungsdichte der Mikrowellen unterhalb der Grenztemperatur gehalten wird und dass die Leistungsdichte über einen Mikrowellensender so hoch eingestellt wird, um das Gasgemisch zu einem möglichst dichten Plasma anzuregen.

7. Verfahren gemäss Anspruch 1, **dadurch gekennzeichnet**, dass als Polymerfolien für Leiterplatten und/oder Folienleiterplatten Polyimidschichten verwendet werden und dass Polyimidschichten mit Grenztemperaturen von 200 °C plasmaerrodiert werden.

8. Verfahren gemäss Anspruch 1, **dadurch gekennzeichnet**, dass als Polymerfolien für Leiterplatten und/oder Folienleiterplatten Polyimidschichten verwendet werden und dass Polyimidschichten mit Erosionsraten grösser 1 µm/min plasmaerrodiert werden.

9. Verfahren gemäss Anspruch 1, **dadurch gekennzeichnet**, dass um die Polymerfolien im Rezipienten eine Heizung angebracht wird, sodass die Polymerfolien von der Heizung weitgehend geschlossen umgeben sind und die Heizung als Strahlenschutz funktioniert und dass durch Heizen des Rezipienten eine möglichst homogene Temperaturverteilung im Rezipienten und eine möglichst homogene Verteilung der Oberflächentemperatur der Polymerfolien gebildet wird und somit eine homogene Plasmaerosion stattfindet

10. Verfahren gemäss Anspruch 1, **dadurch gekennzeichnet,** dass das in den Rezipienten einströmende Gase an Prallwänden vermischt wird, dass das Gasgemisch über Öffnungen in Verteilerplatten homogen abgesaugt wird und dass dadurch ein möglichst gleichmässiger Gasfluss im Rezipienten mit einer homogenen Verteilung reaktiver Teilchen im Plasma gebildet wird und somit eine homogene Plasmaerosion stattfindet.

11. Verfahren gemäss Anspruch 1, **dadurch gekennzeichnet**, dass die Polymerfolien in einem Beschickungskorb eingespannt werden und dass durch Drehen des Beschickungskorbs im Gasfluss eine homogene Verteilung reaktiver Teilchen im Plasma gebildet wird und somit eine homogene Plasmaerosion stattfindet.

12. Verfahren gemäss Anspruch 11, **dadurch gekennzeichnet**, dass die Polymerfolien durch Einspannen im Beschickungskorb längs zum Gasfluss diesem minimale Widerstände bieten und gleichmässig von reaktiven Teilchen des Plasmas überströmt werden und somit eine homogene Plasmaerosion stattfindet.

13. Verfahren gemäss Anspruch 1, **dadurch gekennzeichnet**, dass in einem vorgeschalteten Verfahrensschritt einer Vorheizphase die Oberflächentemperatur durch Zünden eines nichterodierenden Plasmas bis knapp unterhalb der Grenztemperatur angehoben wird, sodass schon zu Beginn der Plasmaerosion mit einer hohen und homogenen Rate erodiert wird und die Erosionsdauer verkürzt wird.

14. Verfahren gemäss Anspruch 1, **dadurch gekennzeichnet,** dass die Oberflächentemperatur und deren Verteilung von einem Pyrometer erfasst wird, dass diese Daten von einem Signalintegrator digitalisiert werden und auf Medien gespeichert werden, dass die Oberflächentemperatur und Verteilung bezüglich ihres zeitlichen Verlaufs, ihrer Kontinuität und ihrer relativen Distanz zu einer oberen Grenztemperatur von einem Algorithmus und einem Computer kontrolliert werden, sodass Differenzen zwischen Sollwert und Istwerten der Oberflächentemperatur und der Verteilung durch Ansteuern eines Temperaturreglers geregelt werden.

15. Verfahren gemäss Anspruch 14, **dadurch gekennzeichnet**, dass bei Anstieg der Oberflächentemperatur über die kritische Grenztemperatur vom Temperaturregler ein Mikrowellensender angesteuert wird und dessen Leistung gedrosselt wird, sodass die 5 Dichte des Plasmas erniedrigt wird und die Oberflächentemperatur unter die kritische Grenztemperatur gesenkt wird.

16. Verfahren gemäss Anspruch 14, **dadurch gekennzeichnet**, dass bei zu 10 niedriger Oberflächentemperatur relativ zur kritischen Grenztemperatur vom Temperaturregler ein Mikrowellensender angesteuert wird und dessen Leistung gesteigert wird, sodass die Dichte des Plasmas erhöht wird und die Oberflächentemperatur bis knapp unterhalb der kritischen Grenztemperatur angehoben wird. 15

## Claims

1. Process for structuring polymer films for printed circuit boards and/or film circuit boards by means of plasma action, using a container, in which container gas mixtures are admitted, which gas mixtures are excited energetically by electromagnetic radiation to form a plasma, which plasma structures the polymer films, the surface temperature of the polymer films in the container being monitored during the structuring, characterized in that the gas mixtures are excited energetically by microwaves, in that the gas pressure in the container is monitored during the structuring, in that, to achieve a maximum erosion rate, linked sets of parameters comprising excitation frequency, gas pressure, gas flow, residence time, surface temperature, container temperature, erosion period, arrangement and movement of the polymer films are used as independent sets for various maximized erosion tasks for controlling the plasma erosion, in that from among the existing sets the set desired for the erosion task is respectively kept ready for loading, in that a microwave energy with a frequency of 2.45 GHz or less is absorbed by the gas mixtures, in that a power density of at least 10 watts/litre is set and in that the surface temperature is controlled just below a material-damaging limit temperature for polymer films so that micro-formations are plasma-eroded in polymer films.

2. Process according to Claim 1, characterized in that micro-formations are homogeneously plasma-eroded with homogeneous distribution of the surface temperature and the gas flow and with the same arrangement and movement of the polymer films.

3. Process according to Claim 1, characterized in that the surface temperature is kept below the limit temperature by the gas pressure and in that the gas pressure is set by the flow and residence time of the gas mixture in the container.

4. Process according to Claim 1, characterized in that the gas pressure is set low enough to avoid the polymer films being heated up above the limit temperature by contact with the gas mixture and in that the gas mixture is set high enough to avoid the polymer films being heated up above the limit temperature by microwaves not absorbed by the gas mixture.

5. Process according to Claim 1, characterized in that the microwave frequency is set sufficiently high to induce a plasma which is as dense as possible and shields microwaves better with increasing frequency.

6. Process according to Claim 1, characterized in that the surface temperature is kept below the limit temperature by setting the power density of the microwaves and in that the power density is set by means of a microwave transmitter sufficiently high to excite the gas mixture to form a plasma which is as dense as possible.

7. Process according to Claim 1, characterized in that polyimide layers are used as polymer films for printed circuit boards and/or film circuit boards and in that polyimide layers with limit temperatures of 200°C are plasma-eroded.

8. Process according to Claim 1, characterized in that polyimide layers are used as polymer films for printed circuit boards and/or film circuit boards and in that polyimide layers are plasma-eroded at erosion rates of greater than 1 µm/min.

9. Process according to Claim 1, characterized in that a heating means is provided around the polymer films in the container, so that the polymer films are largely enclosed by the heating means and the heating means functions as radiation protection and in that heating the container is used as a means of forming a temperature distribution in the container which is as homogeneous as possible and a distribution of the surface temperature of the polymer films which is as homogeneous as possible and consequently homogeneous plasma erosion takes place.

10. Process according to Claim 1, characterized in that the gas flowing into the container is mixed at baffle walls, in that the gas mixture is homogeneously extracted via openings in distributor plates and in that this has the effect of forming a gas flow in the container which is as uniform as possible with a homogeneous distribution of reactive particles in the plasma and consequently homogeneous plasma erosion takes place.

11. Process according to Claim 1, characterized in that the polymer films are clamped in a charging basket and in that, by turning the charging basket in the gas flow, a homogeneous distribution of reactive particles in the plasma is formed and consequently homogeneous plasma erosion takes place.

12. Process according to Claim 11, characterized in that, by being clamped in the charging basket longitudinally with respect to the gas flow, the polymer films offer minimal resistances to the gas flow and are flowed over uniformly by reactive particles of the plasma and consequently homogeneous plasma erosion takes place.

13. Process according to Claim 1, characterized in that, in a prior process step of a preheating phase, the surface temperature is raised to just below the limit temperature by igniting a non-eroding plasma, so that a high and homogeneous rate of erosion is obtained right at the beginning of the plasma erosion and the erosion period is shortened.

14. Process according to Claim 1, characterized in that the surface temperature and its distribution are sensed by a pyrometer, in that these data are digitized by a signal integrator and stored on media, in that the surface temperature and distribution are monitored with respect to their variation over time, their continuity and their relative distance from an upper limit temperature by an algorithm and a computer, so that differences between the setpoint value and actual values of the surface temperature and the distribution are controlled by activating a temperature controller.

15. Process according to Claim 14, characterized in that, when there is a rise in the surface temperature above the critical limit temperature, a microwave transmitter is activated by the temperature controller and the output of the said transmitter is cut back, so that the density of the plasma is reduced and the surface temperature is lowered below the critical limit temperature.

16. Process according to Claim 14, characterized in that, when the surface temperature is too low in relation to the critical limit temperature, a microwave transmitter is activated by the temperature controller and its output is increased, so that the density of the plasma is increased and the surface temperature is raised to just below the critical limit temperature.

## Revendications

1. Procédé de structuration de feuilles polymères pour plaques conductrices et/ou plaques conductrices en feuille, au moyen de l'action d'un plasma, avec utilisation d'un récipient, des mélanges de gaz étant introduits dans le récipient, lesquels mélanges de gaz sont excités énergétiquement en un plasma par un rayonnement électromagnétique, lequel plasma structure les feuilles polymères, la température de surface des feuilles polymères dans le récipient étant surveillée pendant la structuration, caractérisé en ce que les mélanges de gaz sont excités énergétiquement par des micro-ondes, en ce que de la pression de gaz dans le récipient est surveillée pendant la structuration, en ce que, pour obtenir un taux maximum d'érosion, on utilise des jeux chaînés des paramètres fréquence d'excitation, pression du gaz, débit de gaz, temps de séjour, température de surface, température du récipient, durée d'érosion, agencement et déplacement des feuilles polymères, sous la forme de jeux indépendants pour des données d'érosion différentes et maximisées, pour contrôler l'érosion par plasma,
en ce que parmi les quantités de jeux existants, on prépare pour le chargement chaque fois le jeu souhaité pour les données d'érosion,
en ce qu'une énergie micro-ondes d'une fréquence de 2,45 GHz ou inférieure est absorbée les mélanges de gaz, en ce que l'on règle une densité de puissance d'au moins 10 Watt/litre, et
en ce que la température de surface est contrôlée pour être située juste en dessous d'une température limite qui endommage le matériau des feuilles polymères, de telle sorte que des micro-formations présentes dans les feuilles polymères soient érodées par plasma.

2. Procédé selon la revendication 1, caractérisé en ce que les micro-formations sont érodées par le plasma de manière homogène, dans une répartition homogène de la température de surface et du débit de gaz, et pour un agencement et un déplacement identiques des feuilles polymères.

3. Procédé selon la revendication 1, caractérisé en ce que la température de surface est maintenue en dessous de la température limite par la pression du gaz, et en ce que la pression du gaz est ajustée le débit et le temps de séjour du mélange de gaz dans le récipient.

4. Procédé selon la revendication 1, caractérisé en ce que la pression du gaz est ajustée à une valeur suffisamment basse pour éviter un échauffement des feuilles polymères au-dessus de la température limite au contact avec le mélange de gaz, et en ce que la pression a une valeur suffisamment élevée pour éviter un échauffement de la feuille polymère au-dessus de la température limite par des micro-ondes non absorbées par le mélange de gaz.

5. Procédé selon la revendication 1, caractérisé en ce que la fréquence des micro-ondes est ajustée suffisamment haut pour exciter un plasma aussi dense que possible et qui offre un meilleur écran aux micro-ondes lorsque la fréquence augmente.

6. Procédé selon la revendication 1, caractérisé en ce que la température de surface est maintenue en dessous de la température limite par ajustement de la densité de puissance des micro-ondes, et en ce que la densité de puissance est ajustée suffisamment haut par l'intermédiaire d'un émetteur de micro-ondes pour exciter le mélange de gaz en un plasma aussi dense que possible.

7. Procédé selon la revendication 1, caractérisé en ce que comme feuilles polymères pour plaques conductrices et/ou pour plaques conductrices en feuille, on utilise des couches de polyimide, et en ce que les couches de polyimide sont érodées par le plasma à des températures limites de 200° C.

8. Procédé selon la revendication 1, caractérisé en ce que comme feuilles polymères pour plaques conductrices et/ou pour plaques conductrices en feuille, on utilise des couches de polyimide, et en ce que les couches de polyimide sont érodées par le plasma à des taux d'érosion supérieurs à 1 µm/min.

9. Procédé selon la revendication 1, caractérisé en ce qu'un chauffage est disposé autour des feuilles polymères dans le récipient de telle sorte que les feuilles polymères soient entourées de manière largement fermée par le chauffage, le chauffage fonctionnant comme protection contre les rayonnements, et en ce que par chauffage du récipient, on forme une répartition de température aussi homogène que possible dans le récipient et une répartition aussi homogène que possible de la température de surface des feuilles polymères, pour qu'ainsi ait lieu une érosion homogène par le plasma.

10. Procédé selon la revendication 1, caractérisé en ce que les gaz pénétrant dans le récipient sont mélangés sur des parois de chicane, en ce que le mélange de gaz est aspiré de façon homogène par des ouvertures ménagées dans des plaques de répartition, en ce que l'on forme ainsi dans le récipient un écoulement de gaz le plus régulier possible avec une répartition homogène des particules réactives dans le plasma, pour qu'ainsi ait lieu une érosion homogène par le plasma.

11. Procédé selon la revendication 1, caractérisé en ce que les feuilles polymères sont tendues dans un panier d'alimentation, et en ce que, par rotation du panier d'alimentation dans l'écoulement de gaz, on forme une répartition homogène des particules réactives dans le plasma pour qu'ainsi ait lieu une érosion homogène par le plasma.

12. Procédé selon la revendication 11, caractérisé en ce que grâce à leur tension dans le panier d'alimentation, les feuilles polymères offrent des résistances minimales à l'écoulement de gaz et sont balayées de manière régulière par les particules réactives du plasma, pour qu'ainsi ait lieu une érosion homogène par le plasma.

13. Procédé selon la revendication 1, caractérisé en ce que dans une étape précédente du procédé, constituée d'une phase de préchauffage, la température de surface est relevée jusque juste en dessous de la température limite par allumage d'un plasma non érosif, de sorte que dès le début de l'érosion par plasma, l'érosion s'effectue à un taux élevé et homogène et que la durée d'érosion soit raccourcie.

14. Procédé selon la revendication 1, caractérisé en ce que la température de surface et sa répartition sont détectées par un pyromètre, en ce que ces données sont numérisées par un intégrateur de signaux et conservées sur des supports, en ce que la température de surface et sa répartition sont contrôlées par un algorithme et un ordinateur en ce qui concerne leur évolution dans le temps, leur continuité et leur distance relative par rapport à une température limite supérieure, de manière à réguler par commande d'un régulateur de température les différences entre la valeur effective et des valeurs de consigne de la température de surface et de la répartition.

15. Procédé selon la revendication 14, caractérisé en ce que lors d'une augmentation de la température de surface au-dessus de la température limite critique, un émetteur à micro-ondes est commandé par le régulateur de température et sa puissance est limitée de telle sorte que la densité du plasma soit diminuée et que la température de surface soit abaissée en dessous de la température limite critique.

16. Procédé selon la revendication 14, caractérisé en ce que lorsque la température de surface est trop basse par rapport à la température limite critique, un émetteur de micro-ondes est commandé par le régulateur de température et sa puissance est augmentée de telle sorte que la densité du plasma soit relevée et que la température de surface soit rehaussée jusque juste en dessous de la température limite critique.
